Europäisches Patentamt

(19) European Patent Office

Office européen des brevets

(11) Numéro de publication: 0 266 229
A1

## (12) DEMANDE DE BREVET EUROPEEN

(21) Numéro de dépôt: 87401790.8

(51) Int. Cl.4: **H 03 M 11/00**

(22) Date de dépôt: 31.07.87

(30) Priorité: 01.10.86 FR 8613695

(43) Date de publication de la demande:
04.05.88 Bulletin 88/18

(84) Etats contractants désignés:
BE CH DE ES FR GB GR IT LI LU NL SE

(71) Demandeur: M.C.B.
11, rue Pierre Lhomme
F-92400 Courbevoie (FR)

(72) Inventeur: Caullet, Alain
23, rue des Morillons
F-75015 Paris (FR)

Houard, Philippe
2, Parc du Château
F-78430 Louveciennes (FR)

(74) Mandataire: Lecca, Jean et al
CABINET PLASSERAUD 84, rue d'Amsterdam
F-75009 Paris (FR)

Une requête en rectification de page 14 et 16 de la description a été présentée conformément à la règle 88 CBE. Il est statué sur cette requête au cours de la procedure engagée devant la division d'examen (Directives relatives à l'examen pratiqué à l'OEB, A-V, 2.2).

(54) Clavier avec dispositif de lecture.

(57) Pour n touches du clavier, le dispositif de lecture comprend: n contacteurs (K), chacun avec un premier contact (4) et un second contact (5) coopérants; un premier conducteur (1) constitué par la connexion en série de résistances étalonnées (7) et éventuellement d'une résistance talon (6), le premier contact des n contacteurs étant connecté aux jonctions (7c) de deux résistances adjacentes et à l'extrémité (7a) d'une résistance étalonnée terminale; un second conducteur (2) connecté au second contact de tous les n contacteurs; une source de tension (V) connectée en (A, B) entre le premier et le second conducteurs; et un troisième conducteur (8) connecté (en 8a) au premier conducteur, qui débite sur son extrémité libre (C) une tension de sortie (F) qui est représentative de la touche actionnée.

FIG.1.

EP 0 266 229 A1

**Description**

"CLAVIER AVEC DISPOSITIF DE LECTURE"

La présente invention concerne les claviers à touches, enfonçables ou non, et elle a essentiellement pour objet un dispositif de lecture associé à un tel clavier.

On connaît l'utilisation généralisée de claviers à touches, par exemple dans les postes téléphoniques pour former le numéro d'appel, dans les systèmes de téléinformatique, dans les dispositifs informatiques, dans les calculettes, dans les dispositifs de commande d'ouverture des portes d'immeubles, cette liste n'étant bien entendu pas limitative.

Généralement les touches du clavier sont disposées suivant une configuration rectangulaire ou matricielle, par lignes et colonnes, la lecture de la touche du clavier qui est enfoncée étant alors faite matriciellement (par la ligne et par la colonne dans lesquelles se trouve la touche enfoncée), ce qui exige un nombre relativement élevé de conducteurs de sortie, à savoir un conducteur par ligne et un conducteur par colonne de touches du clavier.

La présente invention vise à simplifier le dispositif de lecture des claviers à touches, enfonçables ou non, notamment en ce qui concerne les conducteurs de liaison qui peuvent être réduits à trois (dont deux pour l'alimentation en énergie électrique du dispositif de lecture et un pour la tension de sortie représentative de la touche actionnée), même pour un nombre relativement élevé de touches (par exemple jusqu'à 20 à 40 touches).

En outre, dans le dispositif de lecture d'un clavier de la technique antérieure, on prévoyait au moins trois feuillets pour porter les éléments constitutifs du dispositif, dont un feuillet intercalaire entre les deux contacts de chaque paire de contacts qui correspondent à une touche. Au contraire, la présente invention permet de réaliser, selon des modes de réalisation préférés, un dispositif de lecture d'un clavier à touches au moyen de deux feuillets seulement.

On peut associer à un dispositif de lecture de clavier selon l'invention un microprocesseur simple, en fait une partie d'un microprocesseur, qui comporte une entrée analogique et une sortie numérique, et prévoir un programme relativement simple destiné à contrôler le microprocesseur pour qu'en réponse à une tension électrique particulière, qui est appliquée sur son entrée analogique et qui est fonction de la touche actionnée, il fournisse en sortie une information numérique, du type série ou parallèle, représentative de cette tension et donc de la touche actionnée.

Plus particulièrement l'invention a pour objet un clavier avec son dispositif de lecture, comportant $n$ touches ($n$ étant un nombre entier au moins égal à 2) et caractérisé en ce qu'il comprend, pour la lecture des $n$ touches, en combinaison:

- $n$ contacteurs, chacun des $n$ contacteurs correspondant à une des $n$ touches et comportant un premier contact et un second contact coopérants, qui sont électriquement connectables par l'actionnement de la touche correspondante;

- un premier conducteur constitué par la connexion en série de $n$ résistances électriques, les premiers contacts des $n$ contacteurs étant connectés au premier conducteur, respectivement aux (n-1) jonctions de deux résistances adjacentes de la série de $n$ résistances et à l'extrémité d'une des deux résistances terminales de cette série;

- un deuxième conducteur, lesdits seconds contacts des $n$ contacteurs étant tous connectés au deuxième conducteur;

- une source d'alimentation en énergie électrique, de tension déterminée, connectée entre une des extrémités du premier conducteur et un autre point des premier et deuxième conducteurs pris dans le groupe constitué par l'autre extrémité du premier conducteur et un point du deuxième conducteur;

- un troisième conducteur connecté à l'un des deux autres conducteurs pour prélever sur celui-ci une tension de sortie dont le niveau est fonction de la touche qui est actionnée et donc du contacteur dont le premier et le second contacts ont été électriquement connectés; et

- des moyens de traitement de ladite tension de sortie afin d'identifier le rang de la touche actionnée en fonction du niveau de cette tension de sortie.

Avantageusement ces moyens sont constitués par un microprocesseur à entrée analogique et sortie numérique qui débite, sous le contrôle d'un programme, une série d'impulsions représentative de la touche actionnée.

Selon un premier mode d'exécution :

- la série des $n$ résistances électriques du premier conducteur est constituée par (n-1) résistances étalonnées de valeurs ohmiques bien définies connectées en série et par une résistance talon connectée à l'une des extrémités de la série des (n-1) résistances, les premiers contacts des $n$ contacteurs étant connectés au premier conducteur, respectivement aux (n-1) junctions successives de deux résistances adjacentes parmi la série des $n$ résistances et à l'extrémité de la résistance étalonnée disposée à l'extrémité de la série des (n-1) résistances opposée à la résistance talon;

- la source d'alimentation en énergie électrique est connectée entre l'extrémité libre de la résistance talon du premier conducteur et un point du deuxième conducteur; et

- le troisième conducteur est connecté à la jonction entre la resistance talon et la résistance étalonnée qui lui est adjacente.

0 266 229

Dans ce premier mode d'exécution les valeurs ohmiques des (n-1) résistances étalonnées, peuvent par exemple,
- soit être toutes égales entre elles et dans ce cas la tension de sortie varie par pas de tension différents lorsqu'on actionne successivement les n touches,
- soit être différentes et choisies pour que ladite tension de sortie varie par pas de tension égaux lorsqu'on actionne successivement les n touches.

Selon un second mode d'exécution :
- le premier conducteur est constitué par la connexion en série de n résistances électriques de valeurs ohmiques bien définies;
- la source d'alimentation est connectée entre les deux extrémités du premier conducteur; et
- le troisième conducteur est connecté à un point du deuxième conducteur.

Dans ce second mode d'exécution les valeurs ohmiques des n résistances sont avantageusement égales entre elles.

Dans un premier mode de réalisation d'un dispositif de lecture de clavier selon l'invention, chaque contacteur comprend en outre une pastille conductrice déplaçable par l'actionnement de la touche correspondante pour connecter électriquement l'un à l'autre le premier contact et le second contact dudit contacteur.

Dans un second mode de réalisation de ce dispositif, le second contact de chaque contacteur est déplaçable lors de l'actionnement de la touche correspondante pour venir s'appliquer contre le premier contact du même contacteur et être donc électriquement connecté à celui-ci.

En ce qui concerne l'ensemble des résistances (dont la résistance talon lorsqu'elle est prévue), des conducteurs et des contacts, il est de préférence réalisé

a) dans ledit premier mode de réalisation (à pastilles conductrices), au moyen
- d'une première feuille de support, sensiblement plane et relativement rigide, qui porte, en tant que circuit imprimé, le premier conducteur avec la série des résistances et avec la série des n premiers contacts, le deuxième conducteur avec la série des n seconds contacts, et le troisième conducteur, les n seconds contacts étant disposés en face des n premiers contacts;
- d'une seconde feuille de support, relativement souple mais présentant un certain plan de référence, qui porte, en tant que circuit imprimé, les pastilles conductrices, la disposition géométrique des pastilles conductrices sur la seconde feuille de support étant en correspondance avec la disposition géométrique de l'ensemble des premiers et seconds contacts sur la première feuille, et les portions de cette seconde feuille qui portent les pastilles conductrices étant écartées dudit plan de référence, afin de former des poches dans lesquelles sont logées lesdites pastilles conductrices; et
- de moyens pour assembler la seconde feuille de support au-dessus de la première feuille de support, avec les pastilles conductrices juste en regard, mais à distance du fait de leur logement dans lesdites poches, des premiers et des seconds contacts correspondants;

b) dans ledit second mode de réalisation (sans pastilles conductrices), au moyen
- d'une première feuille de support, sensiblement plane et relativement rigide, qui porte, en tant que circuit imprimé, le premier conducteur avec la série des n résistances et avec la série des n premiers contacts, et le troisième conducteur;
- d'une seconde feuille de support, relative ment souple, mais présentant un certain plan de référence, qui porte, en tant que circuit imprimé, le deuxième conducteur avec la série des n seconds contacts, la disposition géométrique des n seconds contacts sur la seconde feuille de support étant en correspondance avec la disposition géométrique des n premiers contacts sur la première feuille, et les portions de cette seconde feuille qui portent les seconds contacts étant écartées dudit plan de référence afin de former des poches dans lesquelles sont logés lesdits seconds contacts; et
- de moyens pour assembler la seconde feuille de support au-dessus de la première feuille de support avec les seconds contacts juste en regard, mais à distance du fait de leur logement dans lesdites poches, des premiers contacts correspondants.

Avantageusement lesdites poches de ladite seconde feuille, dans les modes de réalisation a) et b) précités, sont formées par gaufrage de la seconde feuille de support; de préférence le gaufrage est obtenu par dépôt d'une pellicule résineuse appliquée sur la seconde feuille, la résine utilisée manifestant, relativement à la seconde feuille, un rétreint différentiel important lors de sa solidification, par exemple au cours de sa polymérisation.

Du fait que les poches permettent, au repos, c'est-à-dire en l'absence d'enfoncement d'une touche, de séparer mécaniquement les deux contacts d'une même paire, on évite la mise en oeuvre d'une feuille intercalaire entre ladite première et ladite seconde feuille, alors que dans la pratique antérieure une telle feuille intercalaire était nécessaire.

Dans le cas où les touches du clavier sont disposées suivant une configuration matricielle, par lignes et colonnes, le premier et le second conducteurs sont méandriformes.

L'invention pourra, de toute façon, être bien comprise à l'aide du complément de description qui suit, ainsi que des dessins ci-annexés, lesquels complément et dessins sont, bien entendu, donnés surtout à titre d'indication.

La figure 1 illustre schématiquement un dispositif de lecture de clavier à touches selon un premier

3

mode d'exécution de l'invention, avec des contacteurs selon le premier mode de réalisation précité (à savoir avec des pastilles conductrices).

La figure 2 représente, en coupe, une partie du dispositif de lecture de la figure 1, avec la structure de type a) précitée.

La figure 3 représente, vu par-dessus, un clavier classique de poste téléphonique.

Les figures 4 à 6 représentent la structure de type a) d'un dispositif de lecture selon les figures 1 et 2 pour le clavier de la figure 3,

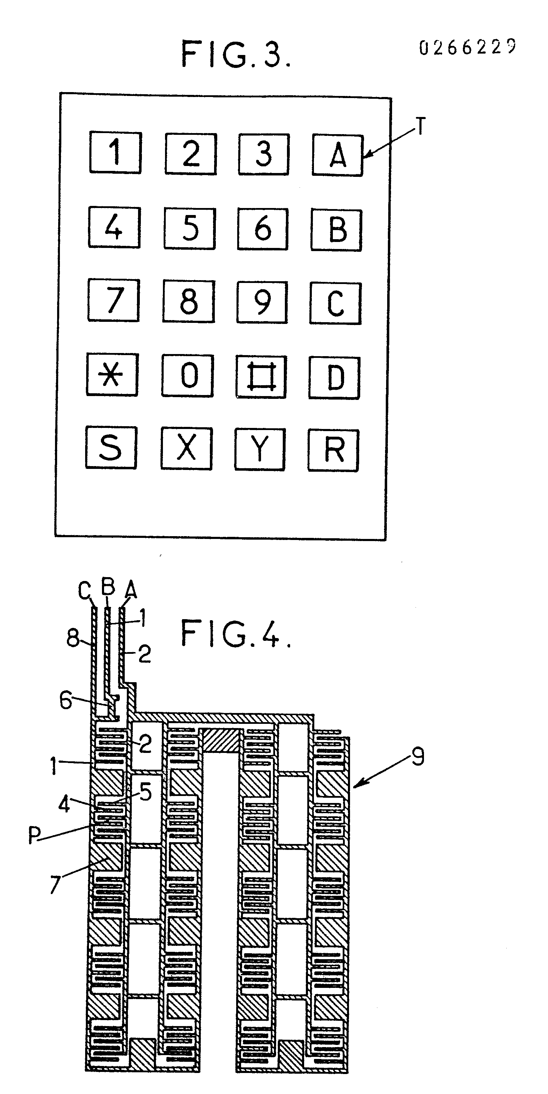

- la figure 4 illustrant l'aspect final de la première feuille de support,

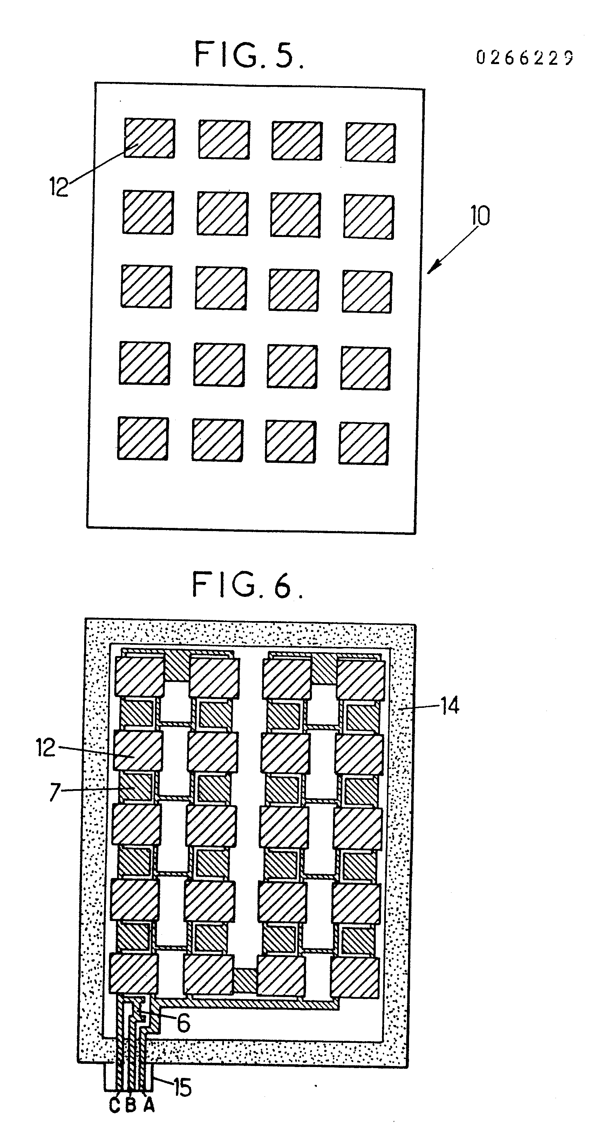

- la figure 5 représentant la seconde feuille de support avec les pastilles conductrices, et
- la figure 6 représentant l'assemblage des deux feuilles de support des figures 4 et 5.

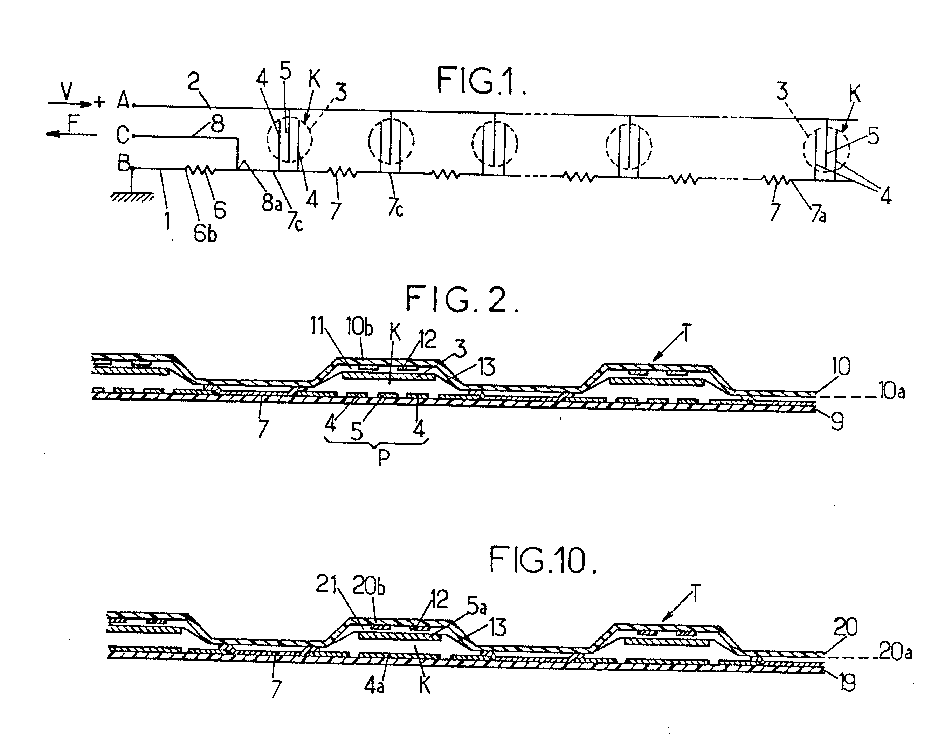

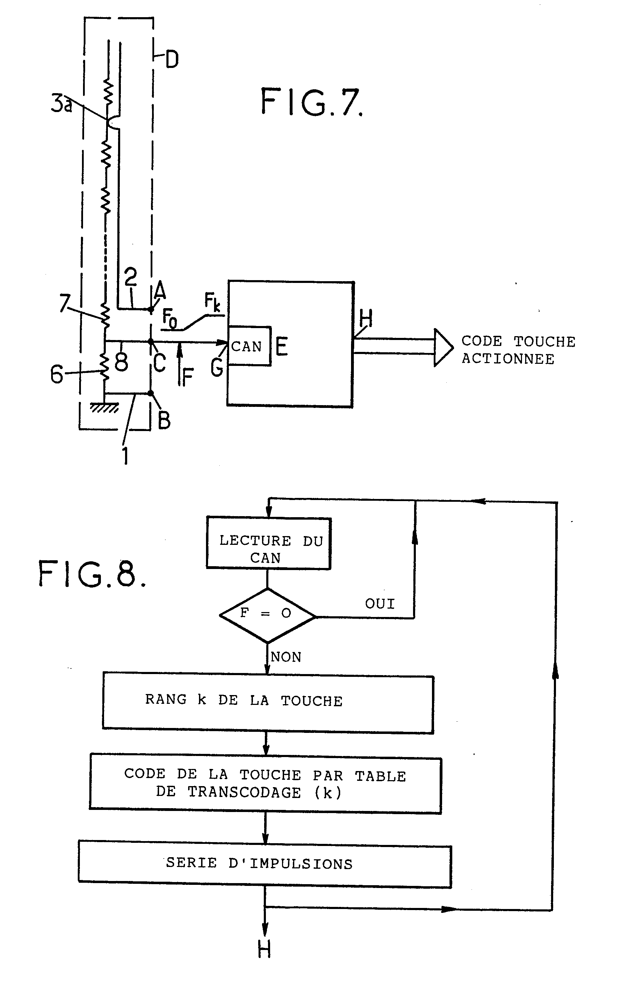

La figure 7 illustre schématiquement un clavier avec dispositif de lecture selon la figure 1 associé à un microprocesseur.

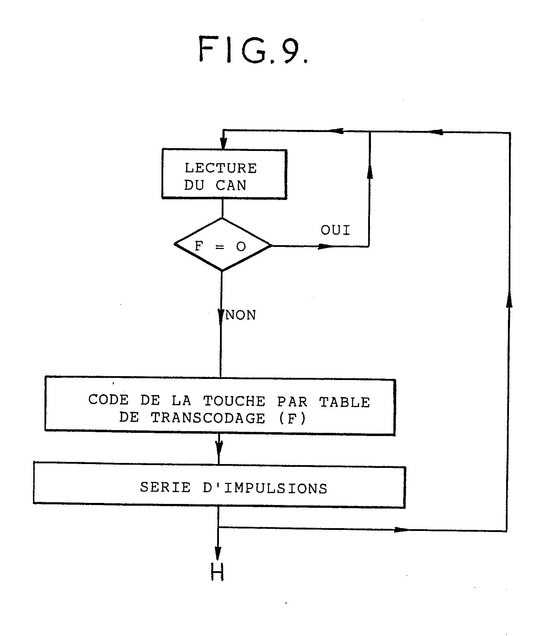

Les figures 8 et 9 représentent les organigrammes des algorithmes mis en oeuvre dans le microprocesseur de la figure 7,
- la figure 8 correspondant au cas où les valeurs ohmiques des (n-1) résistances étalonnées sont toutes identiques entre elles et les tensions de sortie du dispositif de lecture varient par pas variables lors de l'enfoncement successif des touches, et
- la figure 9 correspondant au cas où les valeurs ohmiques des (n-1) résistances étalonnées sont différentes et choisies telles que les tensions de sortie du dispositif de lecture varient par pas constant lors de l'enfoncement des touches successives.

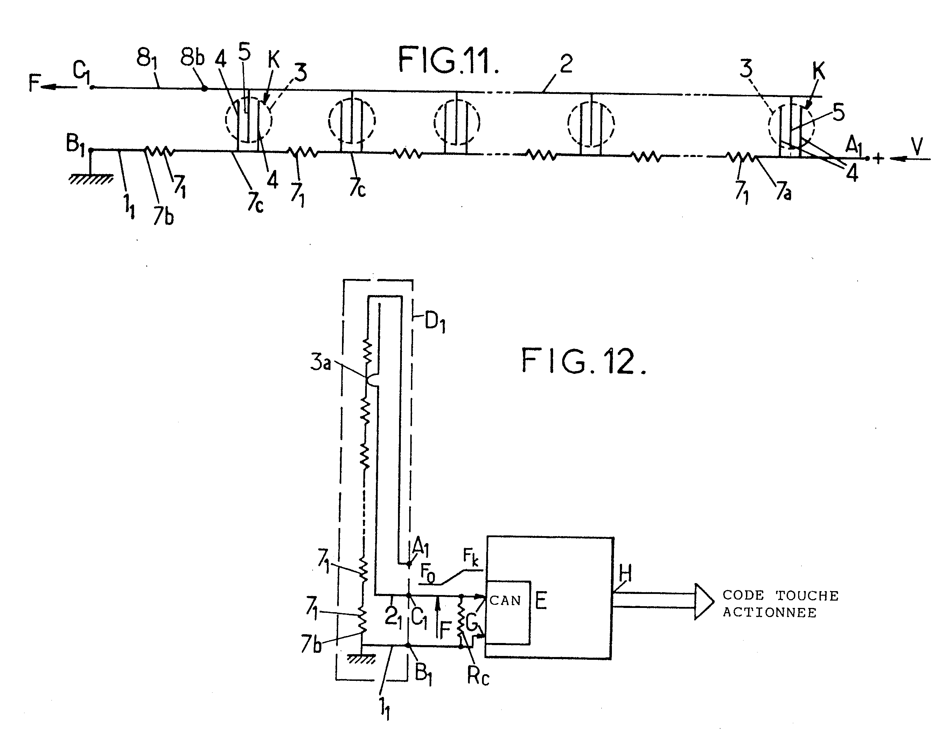

La figure 10 représente, en coupe, une partie d'un dispositif de lecture de clavier à touches selon le premier mode d'exécution de l'invention (comme la figure 2), mais selon le second mode de réalisation (sans pastilles conductrices), avec la structure de type b) précitée.

La figure 11 illustre schématiquement un dispositif de lecture de clavier à touches selon un second mode d'exécution de l'invention, avec des contacteurs selon le premier mode de réalisation précité (à savoir avec des pastilles conductrices).

La figure 12 illustre schématiquement le clavier avec le dispositif de lecture selon la figure 11 associé avec un microprocesseur.

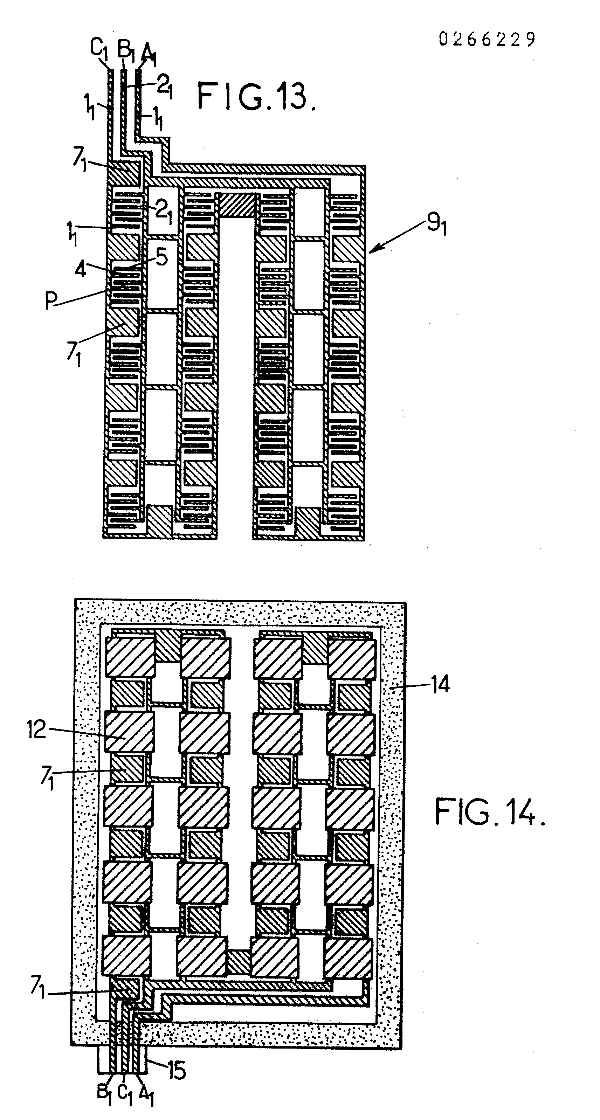

Les figures 13 et 14 représentent la structure de type a) d'un dispositif de lecture selon les figures 11 et 2, pour le clavier de la figue 3,
- la figure 13 illustrant l'aspect final de la première feuille de support, et
- la figure 14 illustrant l'assemblage des deux feuilles de support selon la figure 13 et la figure 5.

Selon l'invention, se proposant de réaliser un clavier avec dispositif de lecture, on s'y prend comme suit ou d'une manière analogue.

En se référant tout d'abord à la figure 1, on voit qu'un dispositif de lecture d'un clavier à touches selon un premier mode d'exécution de l'invention comprend, pour la lecture de $\underline{n}$ touches ($\underline{n}$ étant un nombre entier au moins égal è deux), un certain nombre d'éléments qui coopèrent avec une source d'alimentation en énergie électrique (non représentée) connectée entre les bornes ou extrémités A et B du dispositif de lecture, la borne B étant par exemple connectée à la masse et la borne A recevant la tension continue positive V.

Le dispositif de lecture comporte tout d'abord une paire de conducteurs, à savoir un premier conducteur 1 et un deuxième conducteur 2, connectés aux bornes B et A respectivement et donc alimentés par ladite source d'énergie électrique.

Il comprend ensuite $\underline{n}$ contacteurs K, à savoir un contacteur correspondant à chacune des $\underline{n}$ touches T (non représentées sur la figure 1, mais illustrées sur la figure 2).

Chaque contacteur K comprend, dans un premier mode de réalisation (illustré sur les figures 1 et 2), au moins un premier contact 4 (constitué en fait par deux pièces de contact) et un second contact 5 (constitué en fait par une seule pièce de contact) normalement non connectés électriquement l'un à l'autre, mais pouvant être connectés électriquement par l'actionnement de la touche T correspondante, qui est apte à déplacer une pastille conductrice 3 pour l'amener contre l'ensemble des pièces de contact des contacts 4, 5. Avantageusement les pièces de contacts d'un contacteur K forment un peigne P à dents conductrices de l'électricité.

Le premier conducteur 1 est en fait constitué par la connexion en série de $\underline{n}$ résistances électriques, à savoir (n-1) résistances étalonnées 7, c'est-à-dire de valeur ohmique bien définie, et une résistance talon 6 connectée à l'une des extrémités, celle du côté de la borne B, de la série des (n-1) résistances étalonnées 7, à savoir à gauche sur les figures 1 et 2, de cette série.

Le premier contact 4 des contacteurs successifs K est connecté aux jonctions successives 7c entre deux résistances successives parmi les $\underline{n}$ résistances 7,6 en série et, pour le dernier contacteur K (le plus à droite sur les figures 1 et 2), à l'extrémité libre 7a de la résistance étalonnée la plus éloignée de la résistance talon 6, tandis que l'extrémité libre 6b de la résistance talon est connectée à la borne d'entrée B.

Le deuxième conducteur 2 est connecté au second contact 5 de tous les contacteurs K.

Enfin un troisième conducteur 8, dont une première extrémité 8a est connectée au premier conducteur 1 à la jonction 7c entre la résistance talon 6 et la résistance étalonnée 7 adjacente, fournit sur sa seconde extrémité C, qui constitue la sortie du dispositif de lecture, une tension de sortie F représentative de la touche qui est actionnée et donc du contacteur K correspondant dont les contacts coopérants 4 et 5 ont été connectés électriquement l'un à l'autre par la pastille mobile 3 associée, du fait de cet actionnement.

Sur la figure 1 on a représenté les résistances 7 et les contacteurs K comme étant alignés, mais bien entendu une telle disposition n'est pas du tout impérative; elle est en fait fonction de la disposition géométrique des touches T du clavier avec dispositif de lecture, disposition qui peut être matricielle (selon un tableau rectangulaire à lignes et colonnes), par exemple comme illustré sur la figure 3, et dans ce cas les conducteurs 1 et 2 ont une configuration méandriforme comme illustré sur la figure 4.

Sur la figure 2 on a illustré un premier mode de réalisation particulier du dispositif de lecture d'un clavier à touches, illustré schématiquement sur la figure 1.

Sur la figure 2 on a d'abord représenté deux feuilles de support 9 et 10, à savoir
- une première feuille 9, sensiblement plane et relativement rigide, qui porte, sous la forme d'un circuit imprimé, l'ensemble des résistances étalonnées 7 et de la résistance talon 6 (non illustrée sur la figure 2) constituant le premier conducteur 1, les premiers contacts 4, le deuxième conducteur 2 (non illustré sur la figure 2), les seconds contacts 5 (en face des premiers contacts 4 coopérants) et le troisième conducteur 8 (non visible sur la figure 2);
- une seconde feuille 10, relativement souple et présentant un plan de référence 10a parallèle au plan de la feuille 9, cette seconde feuille portant, sous la forme d'un circuit imprimé, les pastilles conductrices 3; la disposition géométrique des pastilles 3 sur la seconde feuille 10 de support est en correspondance avec la disposition géométrique des contacts 4,5 coopérants sur la première feuille 9; les portions 10b de cette seconde feuille 10 qui portent les pastilles 3 sont écartées (vers le haut sur la figure 2) dudit plan de référence 10a afin de former des poches 11 dans lesquelles sont logées les pastilles 3.

De préférence au moins les portions 10b sont transparentes et comportent, entre les pastilles conductrices 3 et leur face inférieure, des repères 12 désignant la touche, par exemple sous la forme d'indications alphanumériques (0, 1, 2...9, A, B, C...), lisibles à travers les portions transparentes 10b.

La formation de poches est avantageusement réalisée par un gaufrage qui assure, au repos, la séparation matérielle et donc l'isolement électrique entre, d'une part, les deux contacts 4,5 correspondants ou associés de chaque contacteur K, qui forment un peigne P, et, d'autre part, la pastille conductrice 3 coopérante, tant que la touche correspondante T n'est pas enfoncée. On évite ainsi l'adjonction d'une feuille intercalaire (comme c'est le cas dans la technique antérieure) entre les premiers et les seconds contacts, d'une part, et les pastilles conductrices, d'autre part, c'est-à-dire entre les feuilles de support 9 et 10.

Le gaufrage est avantageusement obtenu par le dépôt d'une pellicule résineuse 13 apte à adhérer à la seconde feuille 10 et qui présente, par rapport à cette feuille, un rétreint différentiel notable lors de sa solidification, par exemple lors de sa polymérisation. La résine constituant la pellicule résineuse peut être par exemple une résine époxy mélangée à un durcisseur approprié, comme cela est bien connu de l'homme de l'art des matières plastiques.

Les deux feuilles 9 et 10 sont rendues solidaires l'une de l'autre au niveau de leurs bords (non visibles sur la figure 2) et éventuellement au niveau d'autres points de leurs surfaces, les moyens de liaison entre les deux feuilles étant de types bien connus (colles, rubans adhésifs, soudures, rivets, etc.).

On va maintenant exposer à titre d'exemple l'application de l'invention, selon le mode de réalisation de la figure 2, au cas particulier d'un clavier matriciel à vingt touches T disposées suivant cinq lignes et quatre colonnes, comme c'est le cas pour un clavier classique de combiné téléphonique. Un tel clavier est illustré sur la figure 3 et il comporte, en plus des dix chiffres (de 0 à 9), un certain nombre de lettres et de signes (les lettres X et Y de la figure 3 n'apparaissant pas généralement sur les claviers classiques).

Le dispositif de lecture de ce clavier est réalisé, conformément au mode de réalisation de la figure 2, comme suit:

a) La première feuille de support 9 est constituée par une feuille en kapton d'épaisseur 0,127 mm.
Après stabilisation thermique pendant 1 heure à 240° C, on nettoie la feuille de kapton du commerce et on applique sur celle-ci (figure 4) successivement, par sérigraphie,
- d'abord à l'encre d'argent, les peignes P comportant les premiers contacts 4 et les seconds contacts 5 (on notera que dans ce mode de réalisation chaque peigne comporte trois contacts 4 et trois contacts 5) et les conducteurs 1, 2 et 8, et
- ensuite à l'encre résistive, les résistances 6 (résistance talon) et 7 du conducteur 1.
La sérigraphie à l'encre d'argent est suivie d'une cuisson de 10 minutes à 150° C, tandis que la sérigraphie à l'encre résistive est suivie d'une cuisson de 60 minutes à 180° C.
On obtient finalement l'aspect méandriforme illustré sur la figure 4.

b) La seconde feuille 10 est constituée par une feuille de kapton également épaisse de 0,127 mm.
Après stabilisation thermique pendant 1 heure à 240° C et nettoyage, cette seconde feuille (figure 5) subit trois opérations de sérigraphie successives, à savoir
- la sérigraphie des repères ou indications alphanumériques (ou de dessins) 12, suivie d'un séchage,
- la sérigraphie de la résine de gaufrage (constituée par une résine époxy avec un durcisseur), suivie d'une cuisson pendant 1 heure à 180° C, et
- la sérigraphie des pastilles conductrices 3 (sur la face opposée donc non visible sur la figure 5) avec une encre d'argent ou une encre de graphite, suivie d'une cuisson pendant 10 minutes à 150° C.
On obtient finalement l'aspect illustré sur la figure 5 pour la face supérieure.

Pour réaliser le dispositif de lecture à partir des deux feuilles 9 et 10 des figures 4 et 5 respectivement, on dispose tout d'abord (figure 6) un cadre 14 de ruban adhésif double face, large de 6 mm, sur la périphérie du clavier, puis on place les deux feuilles 9 et 10 des figures 4 et 5 vis-à-vis l'une de l'autre pour que les peignes P à contacts 4 et 5, d'une part, et les pastilles conductrices 3, d'autre part, se fassent face et se correspondent, les poches 11 assurant un écartement d'environ 0,2 mm entre les contacts 4 et 5, d'une part, et la pastille coopérante 3, d'autre part, d'un contacteur K. Au-dessus de chaque contacteur, on voit sur la figure 6 l'indication du repère 12.

La liaison électrique entre le clavier, avec son dispositif de lecture, et un microprocesseur à entrée analogique est réalisée au moyen d'un connecteur 15 pour câble souple, à contacts étamés.

Lorsque les bornes d'entrée A et B du dispositif de lecture de la figure 1 sont connectées à une source d'énergie électrique de tension continue V, la tension F disponible sur la borne de sortie C est donnée par la formule

$$F = \frac{V \cdot R_0}{R_1 + R_0} \qquad (1)$$

en appelant $R_0$ la valeur de la résistance talon 6 et $R_1$ la somme (qui peut être nulle) des valeurs des résistances étalonnées 7 disposées à gauche (en regardant la figure 1) du contacteur K effectivement fermé, c'est-à-dire correspondant à la touche T actionnée.

Si les (n-1) résistances étalonnées 7 ont toutes la même valeur ohmique R, on a

$$R_1 = (k - 1) R \qquad (2)$$

en appelant k le rang de la touche actionnée depuis la gauche sur les figures 1 et 2.

A titre d'exemple, on a utilisé, pour les (n-1) résistances étalonnées 7, une valeur ohmique identique de 200 ohms, tandis que la résistance talon 6 avait une valeur ohmique de 1000 ohms, et la tension d'alimentation appliquée entre les points A et B était de 5 volts (R = 200 ohms, $R_1$ = 1000 ohms et V = 5 volts). Lors de l'enfoncement des touches successives on obtenait sur la sortie C les tensions suivantes en volts : 5; 4,15; 3,5; 3; 2,75; 2,5; 2,25; 2,05; 1,9; 1,8.

A titre de variante, on peut prévoir des valeurs ohmiques différentes pour les (n-1) résistances 7, ces valeurs ohmiques étant choisies pour obtenir un pas de tension constant entre deux touches successives, ce qui facilite le traitement de la tension de sortie F disponible au point C.

Si l'on choisit par exemple un pas de tension de 250 mV, les (n-1) résistances 7 successives peuvent présenter les valeurs suivantes en ohms (pour une résistance talon 6 égale à 1000 ohms) : 53; 57; 65; 70; 83; 96; 110; 128; 154; 180; 220; 280; 360; 440; 700; 1000; 1600; 3400; 10.000.

On se réfère maintenant à la figure 7 pour exposer le principe du décodage de la tension F disponible au point C de sortie d'un clavier avec dispositif de lecture selon l'invention.

Sur la figure 7 on a représenté schématiquement le clavier avec dispositif de lecture (rectangle D) avec la résistance talon 6 et les (n-1) résistances 7 et un contacteur K (dont la pastille 3a a été illustrée) fermé; on a également illustré à l'intérieur du rectangle D les conducteurs 1, 2 et 8, ainsi que les extrémités A et B des conducteurs 1 et 2.

Quand aucun des contacteurs K est fermé, la tension de sortie disponible au point C est nulle (tension nulle représentée par $F_0$); l'enfoncement d'une touche provoque le passage de la tension F de la valeur nulle $F_0$ à une valeur $F_k$ qui varie en fonction du rang k de la touche enfoncée et est représentative de cette touche.

La tension F ($F_0$ ou $F_k$), disponible en C, est normalement appliquée à un microprocesseur E qui comporte une entrée analogique G, un convertisseur analogique/numérique (CAN), et une sortie numérique H.

Sur la figure 8 on a illustré un programme du microprocesseur qui permet de déduire, à partir de la tension F, la touche qui a été actionnée en fournissant en H une information numérique, soit en parallèle, soit en série, et alors H débite, comme discuté ci-dessous, une série d'impulsions représentative de cette touche.

La figure 8 correspond au premier cas précité dans lequel la résistance talon 6 a la valeur de 1000 ohms, tandis que les (n-1) résistances 7 ont chacune la valeur de 200 ohms.

Dans ce cas on déduit des formules (1) et (2) précitées

$$F = \frac{V.R_0}{k'R + R_0}$$

avec k' = k - 1, d'où

$$k'R + R_0 = \frac{V.R_0}{F} \quad \text{et donc} \quad k'R = \frac{V.R_0}{F} - R_0 = R_0\left(\frac{V-F}{F}\right)$$

$$\text{soit finalement } k = k' + 1 = \frac{R_0(V-F)}{R.F} - 1 \qquad (3)$$

Revenant maintenant à la figure 8, on voit que les opérations successives imposées par le programme sont les suivantes.

On réalise d'abord la lecture du convertisseur analogique/numérique (CAN) d'entrée, ce qui donne F.

Si $F = O$, ce qui signifie qu'aucune touche n'est enfoncée ($F = F_0$), on recommence la lecture du CAN.

Si F est différent de O, on détermine le rang k de la touche actionnée, donné par la formule (3) précédente.

On en déduit ensuite le code de la touche de rang k grâce à une table de transcodage qui est en mémoire dans le microprocesseur E et qui donne le code de la touche en fonction du rang k.

L'opération suivante consiste à déterminer, à partir du code de la touche, la série d'impulsions correspondant à la touche en question, cette série d'impulsions sortant en H (figure 7) pour l'utilisation envisagée.

Puis on recommence la lecture du CAN.

La figure 9 est analogue à la figure 8, mais elle représente l'organigramme d'un programme plus simple correspondant au deuxième cas particulier envisagé ci-dessus, à savoir lorsque les (n-1) résistances 7 ont des valeurs ohmiques, différentes entre elles, telles que la tension F de sortie en C varie avec un pas de tension constant (de par exemple 250 mV) lorsque l'on passe de l'actionnement d'une touche à l'actionnement de la touche suivante.

Sur la figure 9 on retrouve les premières opérations de la figure 8, à savoir la lecture du CAN et la comparaison de la valeur de F avec la valeur nulle $F_0$.

Par contre on ne passe pas par l'opération suivante de la figure 8, à savoir la détermination du rang k de la touche, mais on procède immédiatement à la détermination du code de la touche, donné directement par une table de transcodage très simple (car le pas de tension est constant entre deux touches successives) et qui est en mémoire dans le microprocesseur et fournit ce code en fonction de la tension F.

Cette opération de détermination du code de la touche est suivie (comme dans l'organigramme de la figure 8) par la détermination d'une série d'impulsions, disponibles également en H sur la figure 7, série qui représente la touche actionnée.

Comme dans le cas de la figure 8, on recommence la lecture du CAN si la réponse à $F = O$ est "OUI" et après chaque émission d'une série d'impulsions sur la sortie H lorsque cette réponse est "NON".

On notera qu'en fait le microprocesseur E est généralement constitué par une partie d'un microprocesseur de type classique - comportant une entrée analogique, un CAN et une sortie numérique - dont on n'utilise qu'une partie, le programme affecté à la déduction de la série d'impulsions, disponible en H, en fonction de la tension d'entrée analogique, disponible en G, étant très réduit, ainsi qu'on se rend compte en considérant la figure 8 ou la figure 9.

Le nombre de touches que peut comporter le clavier est limité uniquement par le pouvoir de résolution du convertisseur analogique/numérique d'entrée du microprocesseur E et par les tolérances sur les valeurs ohmiques des résistances 6 et 7 (figures 1 et 7).

Bien entendu on peut, si on le désire, lire un plus grand nombre de touches, en répartissant celles-ci en plusieurs groupes, chaque groupe étant lu par un dispositif de lecture du type décrit ci-dessus, les dispositifs de lecture des différents groupes de touches étant associés et débitant sur plusieurs entrées analogiques d'un microprocesseur commun.

Dans ce cas, on a intérêt à substituer au mode de réalisation des figures 1 et 2, à pastilles conductrices, un second mode de réalisation dans lequel chaque contacteur K comporte un premier contact connecté au premier conducteur, comme le premier contact des figures 1 et 2, et un second contact connecté au deuxième conducteur, comme le second contact des figures 1 et 2, mais pas de pastille conductrice, le deuxième conducteur et les seconds contacts étant portés par la seconde feuille de support et non plus par la première feuille de support.

Un tel mode d'exécution est illustré sur la figure 10 et il comporte essentiellement:
- une première feuille de support rigide plane 19 avec le premier conducteur 1 et ses résistances 6 et 7 (la résistance talon 6 n'étant pas illustrée sur la figure 10), les premiers contacts 4a et le troisième conducteur 8 (non visible sur la figure 10);

7

- une seconde feuille de support 20 souple ayant un plan de référence 20a et comportant des poches 21, avec le deuxième conducteur 2 (non illustré sur la figure 10) et les seconds contacts 5a logés dans les poches au niveau des portions 20b de cette seconde feuille.

Sur la figure 10 on a donné aux éléments (7,12, 13,K,T) correspondant à ceux de la figure 2 les mêmes références.

Sur la figure 11 on a illustré un second mode d'exécution du dispositif de lecture de clavier selon l'invention, alors que la figure 1 illustrait le premier mode d'exécution.

Dans le mode d'exécution de la figure 1, le premier conducteur 1 comportait une résistance talon 6 en plus de $(n-1)$ résistances étalonnées 7, la source d'alimentation était connectée entre les extrémités B et A du premier conducteur 1 et du deuxième conducteur 2 respectivement, et la tension de sortie F représentative de la touche actionnée était disponible sur une extrémité C du troisième conducteur 8 dont l'autre extrémité 8a était connectée entre la résistance talon 6 et la résistance étalonnée 7 la plus voisine du conducteur 1.

Au contraire dans le mode d'exécution de la figure 11, le premier conducteur $1_1$ ne comporte que des résistances étalonnées $7_1$, la source d'alimentation en énergie électrique est connectée entre les extrémités $A_1$ et $B_1$ du premier conducteur $1_1$, et la tension de sortie F représentative de la touche actionnée est disponible sur une extrémité $C_1$ du troisième conducteur $8_1$ dont l'autre extrémité est connectée au point 8b du conducteur 2 (en fait les conducteurs 2 et 8 ne constituent qu'un seul élément).

A part ces différences, les montages des figures 1 et 11 sont analogues et on a utilisé les mêmes références sur les deux figures pour les éléments correspondants, notamment les contacts 4 et 5 et les pastilles 3 des contacteurs K.

Le mode d'exécution de la figure 11 est avantageux, d'une part, par ce qu'il est plus simple et, d'autre part, du fait que, si l'on choisit la même valeur ohmique pour toutes les résistances étalonnées $7_1$ formant le premier conducteur $1_1$, on obtient des pas de tension égaux d'un contacteur K au suivant, c'est-à-dire d'une touche T à la suivante. On cumule ainsi les avantages des deux variantes envisagées pour les valeurs des résistances dans le cas du montage selon la figure 1, à savoir la réalisation plus facile de résistances de même valeur ohmique, d'une part, et l'obtention d'un pas constant d'un contacteur K à l'autre, d'autre part.

Avec le montage de la figure 11, la formule (1) donnant la valeur de la tension de sortie F en fonction de la différence de potentiel V fournie pour la source d'alimentation est remplacée par la formule:

$$F = \frac{k}{n} \quad (4),$$

dans laquelle $\underline{k}$ désigne le rang de la touche actionnée, $\underline{n}$ le nombre total de touches et V la tension appliquée par la source d'alimentation.

Par exemple si V = 5 volts et $\underline{n}$ = 20, F prend, pour les touches successives de rang 1 à 20, les valeurs suivantes en volts: 0,25; 0,5; 0,$\overline{75}$..., k x 0,25..., 5.

De la formule (4) on déduit facilement $k = \frac{F \cdot n}{V}$

et on peut mettre en œuvre l'ordinogramme de la figure 9 (qui correspond à des pas constants) avec un pas en volts de $\quad \frac{V}{n} = \frac{5}{20} \quad = 0,25$

(comme cela apparaît sur la liste ci-dessus des vingt valeurs en volts).

Sur la figure 12 on a illustré la connexion entre dispositif de lecture selon la figure 11, dont on a repris les éléments essentiels avec les mêmes références et qui est désigné dans son ensemble par $D_1$, et un microprocesseur E mettant en oeuvre l'ordinogramme de la figure 9 (et qui est du même type que le microprocesseur E de la figure 7 qui coopérait avec le dispositif de lecture D selon la figure 1).

Ce microprocesseur E comporte un convertisseur analogique/numérique CAN qui reçoit la tension F représentative de la touche actionnée et qui est appliqué sur l'entrée G du CAN. La sortie H du microprocesseur E est constituée, comme dans le cas de la figure 7, par des séries d'impulsions représentant chacune, en numérique, la touche actionnée.

On notera entre l'ensemble de la figure 12 et l'ensemble de la figure 7, une différence constituée par la résistance de charge Rc, disposée entre les bornes de l'entrée du CAN, qui fixe le potentiel électrique à vide à l'entrée du CAN. La valeur ohmique de la résistance de charge Rc doit être nettement supérieure à celle du conducteur $1_1$, c'est-à-dire à la somme des valeurs ohmiques des résistances $7_1$; par exemple la valeur ohmique de la résistance Rc peut être égale à dix fois la valeur ohmique de la résistance du conducteur $1_1$; ainsi pour un clavier à vingt touches comportant donc vingt résistances $7_1$ ayant toutes une valeur ohmique de 200 ohms, c'est-à-dire pour une résistance totale du conducteur 1 de 4000 ohms, on peut prendre Rc = 40000 ohms.

A la place de la résistance de charge Rc aux bornes d'entrée du CAN on peut prévoir un amplificateur présentant une impédance d'entrée élevée ou une autre unité électronique pemettant de discriminer sans confusion autant de pas de tension qu'il y a de touches dans le clavier et donc de contacteurs K.

On notera que la résistance de charge Rc a été considérée comme ne faisant pas partie du dispositif de lecture du clavier, mais plutôt comme disposée à l'entrée du CAN, du fait que sa valeur ohmique est en général choisie en fonction des caractéristiques du microprocesseur E avec son CAN et que le rapport des valeurs ohmiques de la résistance Rc et du conducteur $1_1$ peut varier considérablement au cours de la vie de l'ensemble clavier-dispositif de lecture, d'une part, et microprocesseur avec son CAN, d'autre part, sans nuire au bon fonctionnement de l'ensemble.

Par contre il y a intérêt à assurer des valeurs ohmiques relatives constantes aux résistances $7_1$ constituant le conducteur $1_1$ (comme aux résistances 7 et 6 constituant le conducteur 1 de la figure 1), et ceci est obtenu avantageusement en réalisant ces résistances simultanément avec le même matériau subissant les mêmes traitements thermiques afin que les rapports entre les valeurs ohmiques exactes de ces résistances restent constants malgré l'évolution due au vieillissement et aux conditions climatiques.

Sur les figures 13 et 14 on a illustré des variantes de réalisation des figures 4 et 6 (qui correspondaient au montage de la figure 1) pour s'adapter au montage de la figure 11.

La figure 13 représente la première feuille de support $9_1$ qui est analogue à la feuille de support 9 de la figure 4 et elle est traitée de la même façon par stabilisation thermique, nettoyage et sérigraphie, d'abord à l'encre d'argent puis à l'encre résistive. Sur la figure 13 on retrouve les références de la figure 11 et une disposition méandriforme analogue à celle de la figure 4, avec les modifications résultant du passage de la configuration de la figure 1 à celle de la figure 11.

Sur la feille $9_1$ de la figure 13 on applique la deuxième feuille 10 de la figure 5 et comportant les pastilles conductrices 12, pour aboutir à la structure de la figure 14 analogue à la figure 6, à part les modifications correspondant au passage de la configuration de la figure 1 à celui de la figure 11.

La mise en oeuvre préférée de la sérigraphie permet de réaliser toutes les résistances 7,6 ou $7_1$ simultanément; dans le cas où elles ont des valeurs ohmiques différentes il suffit de faire varier le rapport longueur/largeur de chaque résistance imprimée par sérigraphie.

L'invention ne se limite pas aux modes d'exécution et de réalisation envisagés, mais en embrasse les variantes.

## Revendications

1. Clavier avec dispositif de lecture, comportant $\underline{n}$ touches ($\underline{n}$ étant un nombre entier au moins égal à 2) et caractérisé en ce qu'il comprend, pour la lecture des $\underline{n}$ touches, en combinaison:
- $\underline{n}$ contacteurs (K), chacun des $\underline{n}$ contacteurs correspondant à une des $\underline{n}$ touches et comportant un premier contact (4;4a) et un second contact (5;5a) coopérants qui sont électriquement connectables par l'actionnement de la touche (T) correspondante;
- un premier conducteur ($1;1_1$) constitué par la connexion en série de $\underline{n}$ résistances électriques ($7,6;7_1$), les premiers contacts des $\underline{n}$ contacteurs étant connectés au premier conducteur, respectivement aux (n-1) jonctions (7c) de deux résistances adjacentes de la série de $\underline{n}$ résistances et à l'extrémité (7a) d'une des deux résistances terminales de cette série;
- un deuxième conducteur (2), lesdits seconds contacts des $\underline{n}$ contacteurs étant tous connectés au deuxième conducteur;
- une source d'alimentation en énergie électrique, de tension déterminée (V), connectée entre une des extrémités ($B;B_1$) du premier conducteur et un autre point ($A;A_1$) des premier et deuxième conducteurs pris dans le groupe constitué par l'autre extrémité ($A_1$) du premier conducteur et un point (A) du deuxième conducteur;
- un troisième conducteur ($8;8_1$) connecté à l'un des deux autres conducteurs pour prélever sur celui-ci (en 8a;8b) une tension de sortie (F) dont le niveau est fonction de la touche qui est actionnée et donc du contacteur dont le premier et le second contacts ont été électriquement connectés; et
- des moyens (E) de traitement de ladite tension de sortie afin d'identifier le rang de la touche actionnée en fonction du niveau de cette tension de sortie.

2. Clavier avec dispositif de lecture selon la revendication 1, caractérisé en ce que lesdits moyens (E) de traitement de la tension de sortie (F) sont constitués par un microprocesseur à entrée analogique et sortie numérique qui débite (en H) sous le contrôle d'un programme, une série d'impulsions représentative de la touche actionnée.

3. Clavier avec dispositif de lecture selon la revendication 1 ou 2, caractérisé en ce que:
- la série des $\underline{n}$ résistances électriques du premier conducteur (1) est constituée par (n-1) résistances étalonnées (7) de valeurs ohmiques bien définies connectées en série et par une résistance talon (6) connectée à l'une des extrémités de la série des (n-1) résistances, les premiers contacts des $\underline{n}$ contacteurs (K) étant connectés au premier conducteur, respectivement aux (n-1) jonctions successives (7c) de deux résistances adjacentes parmi la série des $\underline{n}$ résistances et à l'extrémité (7a) de la résistance étalonnée disposée à l'extrémité de la série des (n-1) résistances opposées à la résistance talon;
- la source d'alimentation en énergie électrique est connectée entre l'extrémité libre (6b) de la résistance talon (6) du premier conducteur (1) et un point (A) du deuxième conducteur (2); et
- le troisième conducteur (8) est connecté (en 8a) à la jonction entre la résistance talon et la résistance étalonnée qui lui est adjacente.

4. Clavier avec dispositif de lecture selon la revendication 3, caractérisé en ce que les valeurs ohmiques des (n-1) résistances étalonnées (7) sont toutes égales entre elles, la tension de sortie (F) variant par pas de tension différents lorsqu'on actionne successivement les $\underline{n}$ touches (T).

5. Clavier avec dispositif de lecture selon la revendication 3, caractérisé en ce que les valeurs ohmiques des (n-1) résistances étalonnées (7) sont choisies pour que la tension de sortie (F) varie par pas de tension égaux lorsqu'on actionne successivement les $n$ touches (T).

6. Clavier avec dispositif de lecture selon la revendication 1 ou 2, caractérisé en ce que:
- le premier conducteur ($1_1$) est constitué par la connexion en série de $n$ résistances électriques ($7_1$) de valeurs ohmiques bien définies;
- la source d'alimentation est connectée entre les deux extrémités ($A_1$,$B_1$) du premier conducteur (1); et
- le troisième conducteur ($8_1$) est connecté à un point (8b) du deuxième conducteur (2).

7. Clavier avec dispositif de lecture selon la revendication 6, caractérisé en ce que les valeurs ohmiques des $n$ résistances ($7_1$) sont égales entre elles, la tension de sortie (F) variant par pas de tension égaux lorsqu'on actionne successivement les $n$ touches (T).

8. Clavier avec dispositif de lecture selon l'une quelconque des revendications précédentes, caractérisé en ce que chaque contacteur (K) comprend en outre une pastille conductrice (3) correspondant chacune à une des $n$ touches (T) et déplaçable par l'actionnement de la touche correspondante pour connecter électriquement l'un à l'autre le premier contact (4) et le second contact (5) dudit contacteur.

9. Clavier avec dispositif de lecture selon l'une quelconque des revendications 1 à 7, caractérisé en ce que le second contact (5a) de chaque contacteur (K) est déplaçable lors de l'actionnement de la touche (T) correspondante pour venir s'appliquer contre le premier contact (4a) du même contacteur et être donc électriquement connecté à celui-ci.

10. Clavier avec dispositif de lecture selon la revendication 8, caractérisé en ce qu'il est constitué:
- d'une première feuille de support ($9$;$9_1$), sensiblement plane et relativement rigide, qui porte, en tant que circuit imprimé, le premier conducteur ($1$;$1_1$) avec la série des $n$ résistances ($7,6$; $7_1$) et avec la série des $n$ premiers contacts (4), le deuxième conducteur (2) avec la série des $n$ seconds contacts (5), et le troisième conducteur ($8$;$8_1$),
les $n$ seconds contacts étant disposés en face des $n$ premiers contacts;
- d'une seconde feuille de support (10), relativement souple, mais présentant un certain plan (10a) de référence, qui porte, en tant que circuit imprimé, les pastilles conductrices (3),
la disposition géométrique des pastilles conductrices sur la seconde feuille de support étant en correspondance avec la disposition géométrique de l'ensemble des premiers et seconds contacts sur la première feuille, et
les portions (10b) de cette seconde feuille qui portent les pastilles étant écartées dudit plan de référence afin de former des poches (11) dans lesquelles sont logées lesdites pastilles conductrices; et
- de moyens (14) pour assembler la seconde feuille de support au-dessus de la première feuille de support, avec les pastilles conductrices juste en regard, mais à distance du fait de leur logement dans lesdites poches, des premiers et des seconds contacts correspondants;

11. Clavier avec dispositif de lecture selon la revendication 9, caractérisé en ce qu'il est constitué
- d'une première feuille de support (19), sensiblement plane et relativement rigide, qui porte, en tant que circuit imprimé, le premier conducteur ($1$;$1_1$) avec la série des $n$ résistances ($7,6$;$7_1$) et avec la série des $n$ premiers contacts (4), et le troisième conducteur ($8$,$8_1$);
- d'une seconde feuille de support (20), relativement souple, mais présentant un certain plan de référence (20a), qui porte, en tant que circuit imprimé, le deuxième conducteur (2) avec la série des $n$ seconds contacts (5),
la disposition géométrique des $n$ seconds contacts sur la seconde feuille de support étant en correspondance avec la disposition géométrique des $n$ premiers contacts sur la première feuille, et
les portions de cette seconde feuille qui portent les seconds contacts étant écartées dudit plan de référence afin de former des poches (21) dans lesquelles sont logés lesdits seconds contacts; et
- de moyens (14) pour assembler la seconde feuille de support au-dessus de la première feuille de support avec les seconds contacts juste en regard, mais à distance du fait de leur logement dans lesdites poches, des premiers contacts correspondants.

12. Clavier avec dispositif de lecture selon la revendication 10 ou 11, caractérisé en ce que lesdites poches (11;21) de ladite seconde feuille (10;20) sont formées par gaufrage de la seconde feuille de support, obtenu par dépôt d'une pellicule résineuse appliquée sur la seconde feuille, la résine utilisée manifestant, relativement à la seconde feuille, un rétreint différentiel important lors de sa solidification.

13. Clavier avec dispositif de lecture selon l'une quelconque des revendications précédentes, caractérisé en ce que, le clavier ayant des touches disposées suivant une configuration matricielle, par lignes et colonnes, le premier et le second conducteur sont méandriformes.

14. Clavier avec dispositif de lecture selon l'une quelconque des revendications précédentes, caractérisé en ce que toutes les résistances ($7,6$;$7_1$) sont réalisées par dépôt simultané sur une feuille de support ($9$;$19$) par sérigraphie.

# FIG.1.

# FIG.2.

# FIG.10.

0266229

# FIG.3.

0266229

# FIG.4.

## FIG. 5.

## FIG. 6.

# FIG.7.

CODE TOUCHE
ACTIONNEE

# FIG.8.

LECTURE DU
CAN

F = O — OUI

NON

RANG k DE LA TOUCHE

CODE DE LA TOUCHE PAR TABLE
DE TRANSCODAGE (k)

SERIE D'IMPULSIONS

H

# FIG.9.

LECTURE
DU CAN

F = O

OUI

NON

CODE DE LA TOUCHE PAR TABLE
DE TRANSCODAGE (F)

SERIE D'IMPULSIONS

H

FIG.11.

FIG.12.

CODE TOUCHE
ACTIONNEE

0266229

FIG.13.

FIG.14.

Office européen
des brevets

**RAPPORT DE RECHERCHE EUROPEENNE**

Numero de la demande

EP 87 40 1790

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | PATENT ABSTRACTS OF JAPAN, vol. 10, no. 35 (E-380)[2092], 12 février 1986; & JP-A-60 191 516 (TOSHINOBU FUTAGAWA) 30-09-1985 * Figure; page E-380 2092 * | 1-3,6 | H 03 M 11/00 |
| A | IDEM | 4,5,7 | |
| Y | PATENT ABSTRACTS OF JAPAN, vol. 8, no. 269 (P-319)[1706], 8 décembre 1984; & JP-A-59 136 841 (MATSUSHITA DENKI SANGYO K.K.) 06-08-1984 * Figure * | 1-3,6 | |
| A | IDEM | 4,5,7 | |
| A | US-A-4 015 254 (STRANDT) * Figure 2; colonne 1, ligne 65 - colonne 2, ligne 49 * | 1,4 | |
| A | FR-A-2 528 194 (VICTOR COMPANY OF JAPAN) * Pages 1-3; page 4, ligne 22 - page 8, ligne 27 * | 1,2 | DOMAINES TECHNIQUES RECHERCHES (Int. Cl.4) H 03 M |
| A | EP-A-0 123 715 (GRUNDIG) * Figures; page 3, ligne 1 - page 4, ligne 24 * | 1-4 | |
| A | GB-A-2 151 379 (ALSOP et al.) * Figures 1-5; page 1, ligne 83 - page 3, ligne 35 * | 1,4,8, 10,12 | |
| A | US-A-4 034 176 (LARSON) * Figures 1-3; colonne 1, ligne 62 - colonne 3, ligne 33 * ---                         -/- | 1,8,9 | |

Le présent rapport a été établi pour toutes les revendications

| Lieu de la recherche | Date d'achèvement de la recherche | Examinateur |
|---|---|---|
| LA HAYE | 06-01-1988 | FEUER F.S. |

Office européen
des brevets

**RAPPORT DE RECHERCHE EUROPEENNE**

Numero de la demande

EP 87 40 1790

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | EP-A-0 131 185 (SIEMENS)<br>* Figure 1; page 3, lignes 13-15 *<br>--- | 1,8,10, 12 | |
| P,A | WO-A-8 701 235 (FUJI RUBBER COMPANY)<br>* Figures; résumé *<br>----- | 1,8,10, 12 | |

DOMAINES TECHNIQUES
RECHERCHES (Int. Cl.4)

Le présent rapport a été établi pour toutes les revendications

| Lieu de la recherche | Date d'achèvement de la recherche | Examinateur |
|---|---|---|
| LA HAYE | 06-01-1988 | FEUER F.S. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
............................................................................
& : membre de la même famille, document correspondant

EPO FORM 1503 03.82 (P0402)